# EUROPEAN PATENT APPLICATION

(11) **EP 4 650 060 A1**
(43) Date of publication of application: **19.11.2025**
(21) Application number: 25175775.3
(22) Date of filing: 12.05.2025
(51) Int. Cl.: B07C 5/342, H05K 13/04, G06Q 10/30, G06V 10/764, G06V 10/82, G06V 20/52, G06V 20/60, G06N 3/02

(54) **ELECTRONIC COMPONENT SELECTION AND RECOVERY METHOD AND RELATED SYSTEM**

(30) Priority: 14.05.2024 IT 202400010795
(71) Applicant: Microtest S.p.A., 56010 Vicopisano (PI) (IT)
(72) Inventor: AMELIO, Giuseppe, 55100 San Pietro (LU) (IT)
(74) Representative: Botti & Ferrari S.p.A.

(57) **Abstract**

Electronic component selection and recovery system (100), comprising the following stations:
- a recognition and classification station (110), arranged to examine a plurality of waste electronic boards (C) identifying one or more valuable electronic components (E) to be reconditioned;
- a disassembly and sorting station (120) arranged to disassemble said electronic components (E) from said waste electronic boards (C) and separate them therefrom;
- a reconditioning station (130) arranged to recondition said electronic components (E), thus obtaining reconditioned electronic components (R);
- a testing station (140) arranged to verify the functionality of said reconditioned electronic components (R) before new entry into a production cycle.

## Description

### Field of application

The present invention relates to an electronic component selection and recovery system, in particular of valuable components mounted on waste electronic boards.

More in detail, the invention relates to a system of the said type, in particular for recognising and selecting objects comprising the electronic components of interest, such as valuable components mounted on electronic boards, aiming at reconditioning and verifying the components themselves.

The invention also relates to a related system for automatically performing the above identified method.

### Prior art

The massive diffusion of electronics, especially consumer electronics, combined with the ever-increasing technological development of this field, inevitably leads to the disposal of a globally significant quantity of electronic waste.

It is known that the separate disposal of such electronic waste is essential: both since they may contain highly toxic substances such as lead, mercury, and cadmium; and since it allows the recovery of valuable materials such as gold, silver, palladium, aluminium, and copper.

On the other hand, the reconditioning of used electronic devices is increasingly encouraged to at least partially stem the waste of resources due to the high rate of replacement in personal and corporate devices.

However, it should be emphasized that technological obsolescence often makes recent devices rapidly unusable, and leads to discarding electronic boards containing relatively high-cost components that potentially can be reused on new boards. To date, only systems for the automated recovery of the valuable materials present in it have been proposed, without ever providing for an industrial system for recovering the entire component.

Therefore, the technical problem underlying the present invention is to provide an automated system and related method for automatically recovering single electronic components starting from an electronic waste comprising obsolete electronic boards.

### Summary of the invention

The above identified technical problem is solved by an electronic component selection and recovery system comprising the following stations:
- a recognition and classification station, arranged to examine a plurality of waste electronic boards (identifying one or more valuable electronic components to be reconditioned);
- a disassembly and sorting station arranged to disassemble said electronic components from said waste electronic boards and separate them therefrom;
- a reconditioning station arranged to recondition said electronic components, thus obtaining reconditioned electronic components;
- a testing station arranged to verify the functionality of said reconditioned electronic components before new entry into a production cycle.

The valuable electronic components to be reconditioned may be, for instance, FPGA (Field Programmable Gate Array) and/or microcontrollers. Generally, all components with a significant unit cost, indicatively higher than a threshold of two dollars, can be reconditioned.

The recognition and classification station comprises an electronic vision system, at least one logical control unit being also provided for identifying the electronic components starting from images acquired by the electronic vision system.

The logical control unit uses a neural network, in particular a convolutional neural network, for identifying the electronic components to be recovered.

It is noted that the above logical control unit may only be used for the recognition and classification station, or may be a central control unit arranged to control the entire system.

The reconditioning station is preferably arranged to carry out at least the cleaning of the contacts and/or the reconstruction of the soldering bubbles of the electronic components.

Preferably, said disassembly and sorting station comprises heating means and/or devices for carrying out chemical attacks, arranged to carry out the disassembly of the electronic components.

Preferably, the testing station comprises one or more automated testing equipment.

Preferably, the logical control unit forwards an identification signal of the identified electronic component to the automated testing equipment for carrying out appropriate functionality verification tests.

Preferably, the system comprises moving means arranged to automatically move the electronic components from the disassembly and sorting station to the reconditioning station and/or the reconditioned electronic components from the reconditioning station to the testing station.

Preferably, the system comprises means for continuously feeding the waste electronic boards to the recognition and classification station and a detection device for detecting the feeding of a waste electronic board to be examined.

Preferably, the automatic feeding means comprise a conveyor belt and/or a mechanical manipulator.

The above identified technical problem is also solved by an electronic component selection and recovery method, comprising the following steps:
- a recognition and classification step, in which a plurality of waste electronic boards are examined, identifying one or more valuable electronic components to be reconditioned;
- a disassembly and sorting step, in which said electronic components are disassembled from said waste electronic boards, separating them therefrom;
- a reconditioning step in which said electronic components are reconditioned, thus obtaining reconditioned electronic components;
- a testing step in which the functionality of said reconditioned electronic components is verified before the new entry into a production cycle.

Said recognition and classification step comprises the following substeps:
- an acquisition sub-step in which an image of the waste electronic board is acquired;
- a classification and sorting sub-step in which predetermined visual features are extracted, by means of trained convolutional filters, in order to identify the valuable electronic components to be reconditioned. Preferably, said waste electronic boards are continuously fed to a recognition and classification station and wherein said recognition and classification step comprises a detection sub-step in which the waste electronic board is detected by a detection device.

Preferably, in said disassembly sub-step, the disassembly is carried out by heat and/or by use of chemical compounds;

Preferably, in the reconditioning step, the cleaning of the contacts and/or the reconstruction of the soldering bubbles of the electronic components is carried out.

Preferably, in the testing step, the admissibility of the main electrical and magnetic quantities of the reconditioned components is evaluated by comparison with standardized parameters stored in a logical control unit.

Preferably, the various steps are controlled sequentially and in an automated manner by a logical control unit.

Preferably, in said classification and sorting sub-step the electronic boards devoid of recoverable valuable components are discarded.

The features and advantages of the present invention will become apparent from the following description, made with reference to the appended drawings given by way of indicative and non-limiting example.

### Brief description of the drawings

In the drawings:
- figure 1 schematically shows the following stations of an electronic component selection and recovery system;
- figure 2 schematically shows a recognition and classification step of the method according to the invention;
- figure 3 schematically shows a disassembly and sorting step of the method according to the invention;

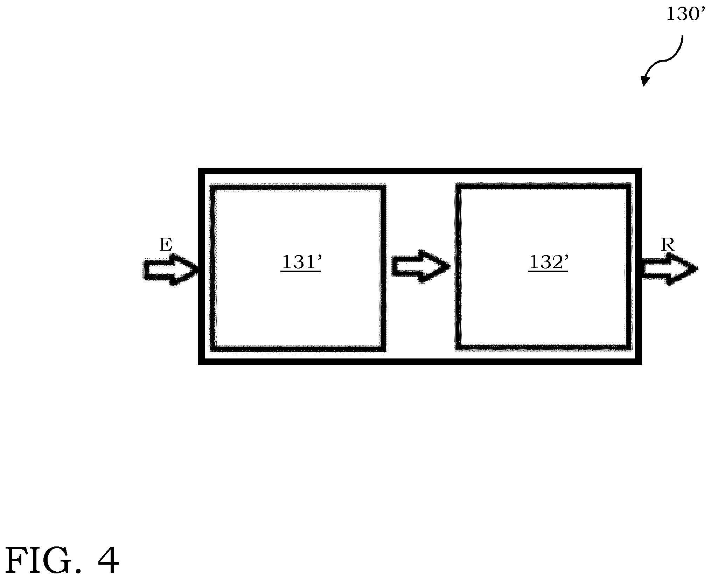

- figure 4 schematically shows a reconditioning step of the method according to the invention.

### Detailed description

With reference to the figures of the appended drawings, reference number 100 schematically and globally identify an electronic component selection and recovery system intended to make a selection and recovery method.

First of all, it is pointed out that the figures represent schematic blocks and are drawn in such a way as to only emphasize the succession of the operating stations, without detailing the concrete making of the machines used.

As identified in the paragraph dedicated to the application field, the system 100 allows both recognizing the valuable electronic components, and separating the electronic components thus identified from the rest of the electronic waste, in particular removing them from a printed circuit board. The system 100 also allows reconditioning the removed electronic components and carrying out tests thereon able to certify the correct operation thereof, so that they can be reused in other electronic boards.

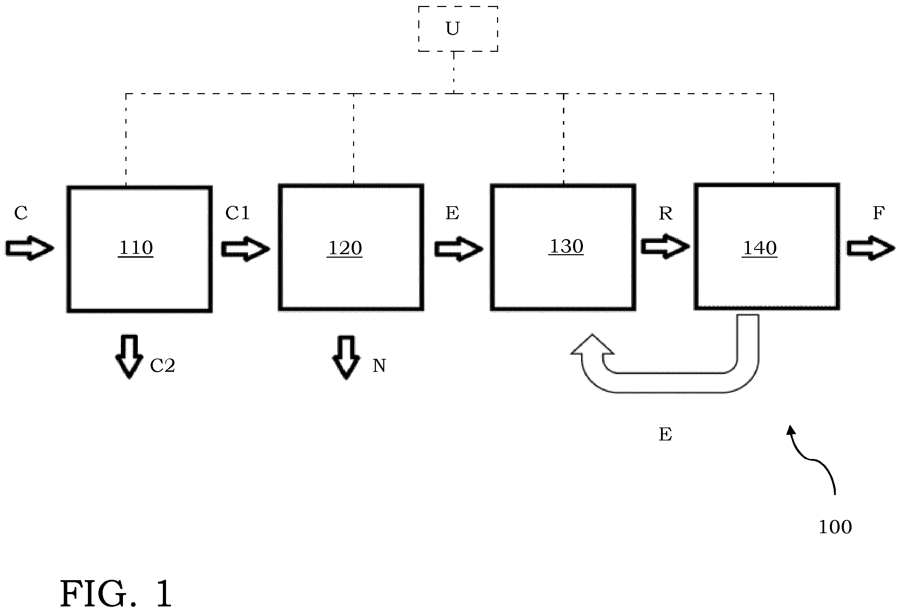

With reference to figure 1, the electronic component selection and recovery system 100 comprises various stations, which may be arranged sequentially as in the figure or even embedded in one or more machines. Each station, as shown in the description below, is arranged to carry out a respective step of the selection and recovery method according to the invention.

A first recognition and classification station 110 is fed with a flow of electronic waste, in particular made of a succession of waste electronic boards C.

Said electronic boards C may be fed by means of a conveyor belt that transport them into the recognition and classification station 110. In this case, the system may comprise a device to sequentially arrange the single electronic boards on said conveyor belt.

Alternatively, the system 100 may use a mechanical manipulator to introduce the single electronic boards C into the recognition and classification station 110, orienting them in a predefined manner to facilitate the recognition of electronic components thereon.

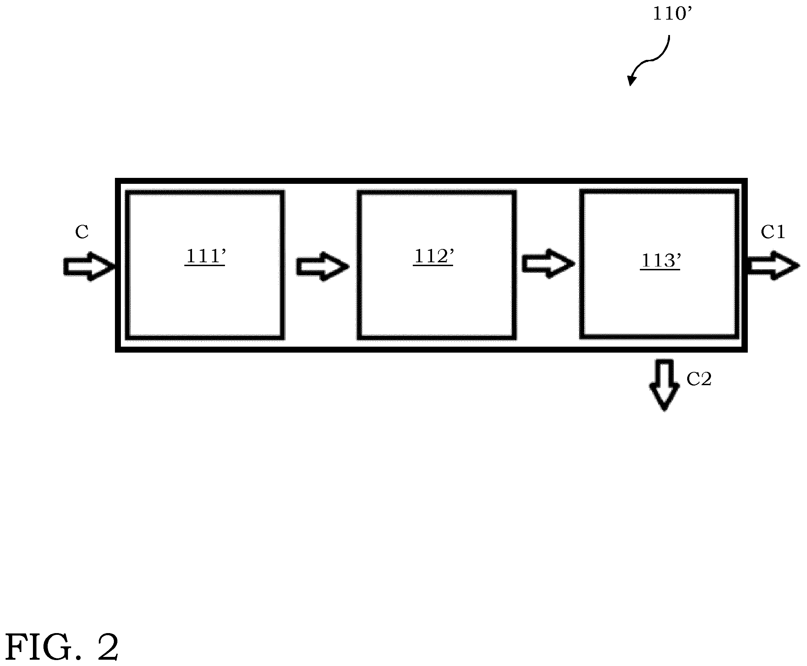

In said first station a corresponding recognition and classification step 110' is carried out. Said step, as detailed in figure 2, may in particular comprise a detection sub-step 111', an acquisition sub-step 112', and a classification and sorting sub-step 113.

Said detection sub-step 111' provides for the verification of the presence of the electronic board C on the conveyor belt by means of a detection element. Said at least one detection element may be an optical sensor or a photoelectric diode able to detect the presence of boards C entering the station.

When the electronic board C is identified, the acquisition sub-step 112' is performed, in which the acquisition of the electronic board C image is obtained by means of an acquisition element. Said acquisition element is preferably represented by a camera. Preferably, lighting means are also provided, consisting for instance of LED devices, so as to light up the electronic board C prior to acquiring the image. When the electronic board C is detected by said at least one detection element, said lighting means and said acquisition element are activated to acquire the image.

Moreover, said image acquisition and processing device is in communication with a logical control unit U, operatively connected with said acquisition element.

Further to said acquisition sub-step 112', the classification and sorting sub-step 113' follows. In said classification and sorting sub-step 113', the images detected and stored in the first logical control unit U may be modified in order to make them more suitable to the classification. Moreover, still in said classification and sorting sub-step 113', the image is processed by a convolutional network that is trained to allow the classification of the visual features needed to understand whether the electronic board C comprises one or more reconditionable components.

To carry out the classification, a cataloguing of the categories of membership of said objects C is provided in said memory unit U, based on the quantity and presence of particular electronic components and/or materials. In particular, the convolutional network is trained through a set of images and data related to the electronic components that are to be identified. The training methods are a part of the prior art, therefore, they will not be dealt with in the description of the present invention.

Moreover, still in said classification and sorting step 113' electronic boards C without valuable recoverable components may be discarded. Said sorting may be performed by means of a motorized actuator capable of moving the at least one electronic board C towards a conveyor belt, slide, or other handling device suitable for the purpose.

Therefore, said recognition and acquisition step 110' provides a plurality of outgoing electronic boards C1 provided with recoverable valuable components, allowing in parallel the elimination of the electronic boards C2 devoid of recoverable components.

Further to said recognition and classification station 110, the disassembly and sorting station 120 is provided. Said station allows separating the electronic components E identified in the previous station with respect to the rest of the electronic board N, carrying out the disassembly starting from the incoming electronic board C1.

The disassembly and sorting station 120 carries out a respective disassembly and sorting step 120'.

Said disassembly and sorting step 120' comprises a disassembly sub-step 121', where the mechanical separation of the electronic components E from the rest of the electronic board N occurs, and where a sorting sub-step 122, in which the electronic components E and the rest of the board N are differentiated and channelled towards different outputs, occurs. This selection is carried out through signals provided by said logical control unit U.

Said disassembly sub-step 121' is carried out by a plurality of instruments needed for disassembling the electronic components E by using heat sources and/or chemical attacks, to dissociate the specific electronic component identified from the rest of the board N.

Said sorting sub-step 122' may provide the use of a mechanical actuator able to direct the waste components N for instance toward an exit slide, whereas the selected electronic components E may be picked up for instance by mechanical manipulators.

Further to said disassembly and sorting station 120 a reconditioning station 130 is provided, where the cleaning and reconditioning procedures of the electronic components are carried out automatically. In said reconditioning step 130, the electronic components E enter and the reconditioned components R exit.

In said reconditioning station 130, in particular, means for cleaning the contacts and/or for reconstructing the soldering bubbles may be provided.

The above mentioned means may be selectively activated based on the type of electronic component E and/or on a diagnostics on the quality of the disassembled component E.

In this way as well, the reconditioning station 130 may comprise a plurality of machines for the synchronous execution of various reconditioning steps 130, specific for different types of incoming electronic components E. To make the organization simpler and more linear, each reconditioning step 130 includes a specific operation.

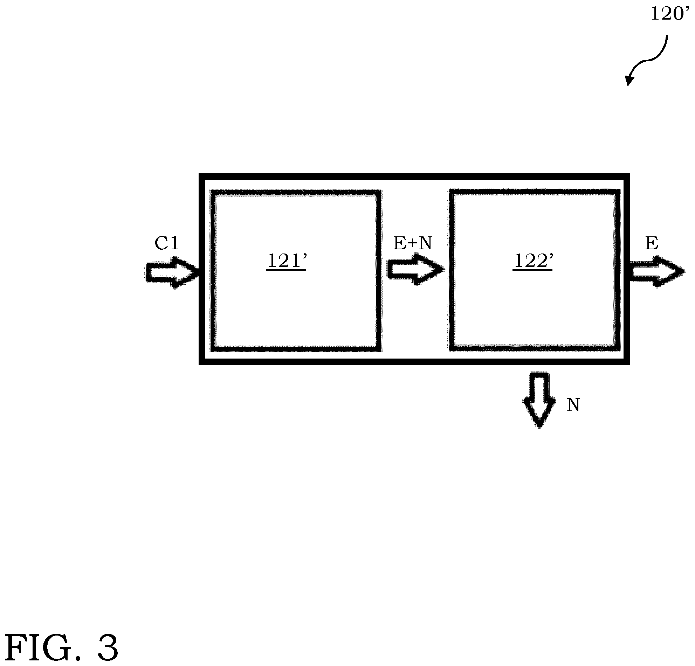

Specifically and as shown in figure 3, the reconditioning station 130 carries out a cleaning sub-step 131' of the contacts and a reconstruction sub-step of the soldering bubbles 132'. However, the presence of further reconditioning operations performed by specific machinery cannot be excluded.

Finally, said selection and recovery system 100 of electronic components provides for a testing station 140 where the performance of the reconditioned R electronic component is monitored. In this step, it is possible to provide tests for each specific electronic component and, for this reason, it is possible to provide for a plurality of machines to perform tests on multiple components simultaneously and according to the needs.

The testing station 140 carries out a testing sub-step 140' of the method according to the invention.

Types of tests, by way of non-limiting example, may be impedance tests, carried out through an impedance analyzer. For instance, to measure impedance, the self-balancing bridge method may be used. Said measurements are highly precise, within a wide bandwidth of 10Hz-50Hz. Specifically, the impedance analyzer is used to measure the current flowing through the component and the voltage at both ends of the component to obtain the Z and θ values. Therefore, L, C, R and other parameters are calculated based on the Z/θ value.

It is also possible to provide a series of test equipment to conduct a comprehensive analysis of the magnetic saturation and permeability features of magnetic components and perform a comprehensive verification of the magnetic saturation current and temperature rise current of magnetic components.

Said testing station 140 is connected to said logical control unit U able to compare the parameter obtained, as a result of the test, with a desired optimal parameter. If the obtained result satisfies the standards set in the logical control unit U, then the final component F can exit the testing station 140, otherwise it can be redirected to the reconditioning station 130 and/or discarded.

In particular, the testing station 140 may use a plurality of automated testing equipment (ATE) of the type per se known.

The present invention is described by way of non-limiting example and therefore it is understood that variations and/or modifications may be made by the persons skilled in the art without departing from the related scope of protection, as defined by the attached claims.

## Claims

1. Electronic component selection and recovery system (100), comprising the following stations:
- a recognition and classification station (110), comprising an electronic vision system, arranged to examine a plurality of waste electronic boards (C) identifying one or more valuable electronic components (E) to be reconditioned;
- a disassembly and sorting station (120) arranged to disassemble said electronic components (E) from said waste electronic boards (C) and to separate them therefrom;
- a reconditioning station (130) arranged to recondition said electronic components (E), thus obtaining reconditioned electronic components (R);
- a testing station (140) arranged to verify the functionality of said reconditioned electronic components (R) before new entry into a production cycle;
- a logical control unit (U) for identifying the electronic components (E) starting from images acquired by the electronic vision system, wherein said logical control unit (U) employs a neural network, in particular a convolutional neural network, for identifying electronic components (E).

2. System (100) according to claim 1, wherein said reconditioning station (130) carries out at least the cleaning of the contacts and/or the reconstruction of the soldering bubbles of the electronic components (E).

3. System (100) according to any one of the preceding claims, wherein said disassembly and sorting station (120) comprises heating means and/or devices for carrying out chemical attacks, arranged to carry out the disassembly of the electronic components (E).

4. System (100) according to any one of the preceding claims, wherein the testing station (140) comprises one or more automated testing equipment (ATE).

5. System (100) according to claim 4, wherein said logical control unit (U) forwards an identification signal of the identified electronic component (E) to the automated testing equipment (ATE) for carrying out appropriate functionality verification tests.

6. System (100) according to any one of the preceding claims, further comprising moving means arranged to automatically move the electronic components (E) from the disassembly and sorting station (120) to the reconditioning station (130) and/or the reconditioned electronic components (R) from the reconditioning station (130) to the testing station (140).

7. System (100) according to any one of the preceding claims, further comprising means for continuously feeding the waste electronic boards (C) to the recognition and classification station (110) and a detection device for detecting the feeding of a waste electronic board (C) to be examined.

8. System (100) according to claim 7, wherein said automatic feeding means include a conveyor belt and/or a mechanical manipulator.

9. Electronic component selection and recovery method, comprising the following steps:
- a recognition and classification step (110'), in which a plurality of waste electronic boards (C) are examined, identifying one or more valuable electronic components (E) to be reconditioned;
- a disassembly and sorting step (120'), in which said electronic components (E) are disassembled from said waste electronic boards (C), separating them therefrom, in turn comprising:
- an acquisition sub-step (112'), in which an image of the waste electronic board is acquired (C); and
- a classification and sorting sub-step (113'), in which predetermined visual features are extracted, using trained convolutional filters, in order to identify the valuable electronic components (E) to be reconditioned;
- a reconditioning step (130') in which said electronic components (E) are reconditioned, thus obtaining reconditioned electronic components (R);
- a testing step (140') in which the functionality of said reconditioned electronic components (R) is verified before the new entry into a production cycle.

10. Method according to claim 9, wherein said waste electronic boards (C) are continuously fed to a recognition and classification station (110) and wherein said recognition and classification step (110') includes a detection sub-step (111') in which the waste electronic board (C) is detected by a detection device.

11. Method according to one of claims 9 or 10, wherein, in said disassembly and sorting step (120'), disassembly is carried out by heat and/or by use of chemical compounds.

12. Method according to one of claims 9-11, wherein, in the reconditioning step (130'), the cleaning of the contacts and/or the reconstruction of the soldering bubbles of the electronic components (E) is carried out.

13. Method according to one of claims 9-12, wherein, in the testing step (140'), the admissibility of the main electrical and magnetic quantities of the reconditioned components (R) is evaluated by comparison with standardized parameters stored in a logical control unit (U).

14. Method according to one of claims 9-13, wherein the various steps are controlled sequentially and in an automated manner by a logical control unit (U).

15. Method according to one of claims 9-14, wherein in said classification and sorting sub-step (113') the electronic boards (C) devoid of recoverable valuable components are discarded.
